# EUROPÄISCHE PATENTSCHRIFT

(11) **EP 3 338 149 B1**
(45) Veröffentlichungstag und Bekanntmachung des Hinweises auf die Patenterteilung: **09.10.2019**
(21) Anmeldenummer: 16753294.4
(22) Anmeldetag: 02.08.2016
(51) Int. Cl.: H02J 13/00, H02B 1/056, H02B 1/20

(54) **VERFAHREN ZUM BETREIBEN EINES STROMVERTEILERS SOWIE STROMVERTEILER**
OPERATION METHOD OF A CURRENT DISTRIBUTOR AND CURRENT DISTRIBUTOR
MÉTHODE D'EXPLOITATION D'UN DISTRIBUTEUR DE COURANT ET DISTRIBUTEUR DE COURANT

(30) Priorität: 06.11.2015 DE 102015221899
(43) Veröffentlichungstag der Anmeldung: 27.06.2018
(73) Patentinhaber: Ellenberger & Poensgen GmbH, 90518 Altdorf (DE)
(72) Erfinder: ASANZA MALDONADO, Diego Fernando, 90403 Nürnberg (DE)
(74) Vertreter: FDST Patentanwälte
(86) Internationale Anmeldenummer: PCT/EP2016/068462
(87) Internationale Veröffentlichungsnummer: WO 2017/076526

(56) Entgegenhaltungen:
- EP-A1- 0 806 751
- WO-A1-2015/062731
- WO-A1-2015/103196
- US-A1- 2013 045 613

## Beschreibung

Die Erfindung betrifft ein Verfahren zum Betreiben eines Stromverteilers mit einer Anzahl von angereihten Anschlussmodulen. Die Erfindung betrifft weiter einen modularen Stromverteiler für eine direkte Montage auf einer Tragschiene, umfassend eine Anzahl von Stromverteilungsmodulen, insbesondere in Form von Reiheneinbaugeräten.

Als Stromverteiler wird im Nachfolgenden insbesondere eine elektrische Installation mit einem oder mehreren elektrischen Laststromkreisen bezeichnet, denen aus einer gemeinsamen Hauptstromleitung ein Strom zugeführt ist. Im Rahmen des Stromverteilers sind Sicherungsmechanismen vorgesehen, die jeden Laststromkreis einzeln gegen eine Überlast und/oder gegen Kurzschluss absichern.

Die Sicherungsmechanismen sind insbesondere mechanische, elektronische oder mechatronische Schutzschalter, die zwischen einem Hauptstromkreis oder einer Einspeisung und den Laststromkreisen verschaltet sind. Die Schutzschalter sind oftmals durch flexible Leitungsdrähte an die Einspeisung und Last einzelverdrahtet. Dadurch ist die Montage eines derartigen Stromverteilers besonders arbeitsaufwändig. Weiterhin ist das durch einen derartigen Stromverteiler gebildete Schaltsystem aufgrund der Einzelverdrahtungen vergleichsweise unübersichtlich, was Reparaturen und nachträgliche Änderungen im Montagezustand des Stromverteilers nachteilig erschwert.

Um den Verschaltungsaufwand herkömmlicher Stromverteiler zu reduzieren, können sogenannte modulare Stromverteiler eingesetzt werden. Derartige Stromverteiler sind aus mehreren einzelnen und miteinander elektrisch leitfähig koppelbaren Stromverteilungsmodulen zusammengesetzt. Die Stromverteilungsmodule sind typischerweise als Reiheneinbaugeräte nebeneinander direkt auf einer Tragschiene (Hutschiene) montierbar und weisen einerseits Anschlüsse für eine Einspeisung und für die Last sowie andererseits mindestens einen sockelartigen Steckplatz zur Zwischenschaltung eines Schutzschalters auf. Die aneinandergereihten Module sind typischerweise mittels einer mehrere Module überbrückenden Stromschiene optisch übersichtlich miteinander elektrisch leitfähig gekoppelt.

Im Rahmen eines solchen Stromverteilers sind derartige, mit Schutzschalter bestückte Stromverteilungsmodule insbesondere an den Zweigstellen vorgesehen, an denen die Laststromkreise von der Hauptstromleitung abzweigen. Die Schutzschalter dienen hierbei dazu, den jeweils zugeordneten Laststromkreis im Bedarfsfall von der stromführenden Hauptstromleitung zu trennen.

Typischerweise werden bei einer Aneinanderreihung einzelner Stromverteilungsmodule Verdrahtungen für eine Signalisierung bereitgestellt. Die eingesetzten Schutzschalter weisen hierfür integrierte Signalkontakte (Öffner und Schließer) auf, die je nach Anwendung im Rahmen einer Einzel- oder Sammelsignalisierung verschaltet und von einem Schaltsignal betätigbar sind.

Aus der US 2013/045613 A1 ist ein Stromverteiler mit einer Anzahl von Anschlussmodulen mit seitlichen Koppelkontakten zur elektrischen oder signaltechnischen Kontaktverbindung mit mindestens einem angereihten weiteren Anschlussmodul bekannt. Zwischen zwei Koppelkontakten ist jeweils ein Sockelwiderstand derart verschaltet, dass die Sockelwiderstände der aneinandergereihten Anschlussmodule eine in Reihe geschaltete Widerstandskette bilden. Die Anschlussmodule sind mit einem betätigbaren Schutzschalter bestückbar, die einen schalterinternen Controller zur Erfassung einer an den jeweils zugeordneten Sockelwiderstand abfallenden Spannung aufweisen.

Bei der Anwendung von seriellen Kommunikations- und Signalisierungsmethoden kann mittels Verdrahtung der Stromverteilungsmodule eine sogenannte Daisy-Chain-Anordnung gebildet werden. Hierbei ist es aus anwendungstechnischer Sicht für eine Bus-Funktionalität wünschenswert, dass jedem Schutzschalter oder jedem Stromverteilungsmodul eine eigene Signal- oder Geräteadresse zugeteilt wird, sodass jeder Schutzschalter im Zuge eines Signalbuses individuell ansprechbar, d. h. insbesondere ansteuerbar ist. Insbesondere im Hinblick auf die modulare Ausgestaltung des Stromverteilers kann es des Weiteren Wünschenswert sein, dass die Adressvergabe auch leere Steckplätze der Module berücksichtigt, sodass, wenn ein Schutzschalter nachträglich eingesteckt wird, keine erneute Adressvergabe erfolgen muss.

Bei einem Fehlerfall, das heißt insbesondere bei einer galvanischen Unterbrechung der Daisy-Chain-Anordnung ist es besonders wünschenswert, möglichst zeitsparend den defekten Schutzschalter und/oder das defekte Stromverteilungsmodul beziehungsweise die Position der Unterbrechung im Reihenverbund zu ermitteln.

Der Erfindung liegt die Aufgabe zugrunde, ein geeignetes Verfahren zum Betrieb eines hinsichtlich einer Kommunikations- und/oder Signalisierungsanwendung geeigneten Stromverteilers anzugeben. Des Weiteren soll ein zur Durchführung des Verfahrens geeigneter Stromverteiler angegeben werden.

Bezüglich des Verfahrens wird die genannte Aufgabe durch die Merkmale des Anspruchs 1 und bezüglich des Stromverteilers mit den Merkmalen des Anspruchs 5 erfindungsgemäß gelöst. Vorteilhafte Ausgestaltungen und Weiterbildungen sind Gegenstand der jeweiligen Unteransprüche.

Der Stromverteiler ist modular mit einer Anzahl von aneinander angereihten oder anreihbaren Anschlussmodulen - nachfolgend verkürzt auch als Module bezeichnet - aufgebaut. Die einzelnen Module und somit der Stromverteiler sind zur direkten Montage auf einer Tragschiene, wie beispielsweise einer Hut- oder G-Schiene geeignet und eingerichtet. Die Module sind hierzu insbesondere nach Art von Reiheneinbaugeräten in einer Reihe nebeneinander auf der Tragschiene montierbar. Das dadurch gebildete Modulpaket ist an einen gemeinsamen ersten Controller (das heißt an ein gemeinsames erstes Steuergerät) angeschlossen.

Die Module weisen jeweils eine Anzahl seitlicher Koppelkontakte zur elektrischen und/oder signaltechnischen Kontaktverbindung mit mindestens einem seitlich an das jeweilige Modul angereihten oder anreihbaren weiteren Modul auf. Modulintern ist zwischen zwei Koppelkontakten jeweils ein Sockelwiderstand derart verschaltet, dass die Sockelwiderstände der aneinandergereihten Module im Verbund des Modulpakets eine in Reihe geschaltete Widerstandskette bilden.

Die Module dienen insbesondere zur Stromverteilung oder Abzweigung an einem mittels einer Zuführungsleitung gekoppelten Laststromkreis und sind jeweils mit einem betätigbaren Schutzschalter bestückt oder bestückbar. Der Schutzschalter unterbricht den jeweils angeschlossenen Laststromkreis selbsttätig im Falle einer auftretenden Überlast oder eines Kurzschlusses.

Die Schutzschalter weisen jeweils einen schalterinternen zweiten Controller (das heißt ein zweites Steuergerät) auf, der - insbesondere zusätzlich zu weiteren Funktionalitäten - zumindest auch zur Erfassung einer an den jeweils zugeordneten Sockelwiderstand abfallenden Spannung dient. Die zweiten Controller versenden in Abhängigkeit von der erfassten Spannung ein Controllersignal an den ersten Controller, wobei der erste Controller eine Gleichstromquelle zur Versorgung und Bestromung der Widerstandskette aufweist.

Dadurch ist ein Stromverteiler bereitgestellt, der hinsichtlich einer Kommunikations- und/oder Signalisierungsanwendung besonders geeignet ist. Durch die Widerstandskette sind die Module nach Art einer Daisy-Chain-Anordnung seriell an den ersten Controller angeschlossen. Durch die modulinterne Widerstandskette ist die Kontaktverbindung auch bei einem nicht mit einem Schutzschalter bestückten Modul nicht unterbrochen. Des Weiteren ergibt sich durch die Kontaktverbindung der Module untereinander ein Stromverteiler mit einem besonders geringen Verdrahtungs- und Verschaltungsaufwand.

Die Module umfassen jeweils ein vorzugsweise flach ausgeführtes (Modul-)Gehäuse aus einem elektrisch isolierenden Material. Die Module sind in einer bevorzugten Einbausituation zweckmäßigerweise mit einer Hauptstromzuführung oder Einspeisung zur Stromverteilung oder Abzweigung gekoppelt.

Bevorzugterweise weist jedes Modul gehäusefrontseitig, das heißt auf der der Tragschiene abgewandten (Gehäuse-)Seite, einen sockelartigen Steckplatz zum Aufstecken des Schutzschalters auf. Mittels des Schutzschalters ist der angeschlossene Laststromkreis galvanisch unterbrechbar beziehungsweise auftrennbar. Die Steckverbindung zwischen dem Modul und dem Schutzschalter ist beispielsweise mit Lamellen-, Bolzen-, oder vorzugsweise Flachsteckern ausgeführt.

Die modulare Bauweise des Stromverteilers ermöglicht einen hohen Vorfertigungsgrad und dadurch vergleichsweise geringe Herstellungs- und Montagekosten. Insbesondere ist es möglich einen Stromverteiler durch eine Aneinanderreihung einer entsprechenden Anzahl von Modulen besonders einfach an eine gewünschte Anzahl anzuschließender Laststromkreise anzupassen. Dadurch ist der Stromverteiler hinsichtlich einer elektrischen Anlage besonders flexibel einsetzbar.

Der Schutzschalter ist typischerweise als ein mechanischer, elektronischer oder mechatronischer Schalter oder als ein Relais ausgeführt, und weist üblicherweise einen Einspeisungsanschluss, über den eine netzseitige und somit stromführende Stromleitung durch einen ersten Steckkontakt mit dem Modul angeschlossen wird, sowie einen Lastanschluss auf, über den die lastseitig abgehende Stromleitung durch einen zweiten Steckkontakt mit dem Modul angeschlossen ist.

Die Schutzschalter sind in dem durch die Module vorgegebenen Rastermaß an dem Stromverteiler anbringbar beziehungsweise bestückbar. Die Module sind insbesondere etwa so breit wie ein Schutzschalter, das heißt ein Modul dient vorzugsweise der Aufnahme jeweils eines Schutzschalters. Vorzugsweise ist es hierbei möglich, die bestückten Schutzschalter des Stromverteilers sowohl in einer Reihenschaltung als auch in einer Parallelschaltung zu betreiben, wobei hierfür optional zusätzliche Anschlüsse an den Modulen vorgesehen sind.

Die Module weisen im Zuge der Ausgestaltung als Reiheneinbaugeräte vorzugsweise gehäuserückseitig eine profilierte Aufnahme (Aufrastnut) zum Aufsetzen des Modulpakets auf die Tragschiene auf. Die Gehäusefrontseite ist somit in der vorgesehenen Einbausituation der Module einem Benutzer zugewandt. Die Profilrichtung der Aufnahme (und der mit dieser korrespondierenden Tragschiene) definiert eine Reihenrichtung, entlang derer mehrere Module im Montagezustand bestimmungsgemäß aneinander aufreihbar sind. Die zu dieser Reihenrichtung senkrecht orientierten Gehäuseseiten sind nachfolgend als (Gehäuse-)Stirnseiten bezeichnet.

Der erste Controller ist vorzugsweise als eine externe Steuereinheit zum Zwecke einer übergeordneten Steuerungsanordnung, einer ferngesteuerten Betätigung der Schutzschalter und/oder zu einer Erfassung von Messwerten sowie zu einer Diagnose im Fehlerfall geeignet und eingerichtet. Im Rahmen der Erfindung ist es beispielsweise ebenso vorteilhaft denkbar, dass der erste Controller als ein Steuermodul im Zuge des Modulpakets an die Anschlussmodule angereiht ist.

Der zweite Controller des Schutzschalters ist weiterhin insbesondere dazu geeignet, in Abhängigkeit eines Schaltsignals des ersten Controllers den Schutzschalter zu betätigen. Hierzu weist der Schutzschalter vorzugsweise zwei mit dem zweiten Controller verschaltete Signalkontakte (Öffner, Schließer) für einen Anschluss an das Modul auf. Des Weiteren umfasst der Schutzschalter mindestens einen Kommunikationskontakt zur Anbindung an eine Kommunikationsleitung, insbesondere im Zuge einer Busverbindung für Signalkontaktfunktionen.

In einer bevorzugten Weiterbildung ist zur Führung der Controllersignale eine durch die Koppelkontakte gebildete Kommunikationsleitung vorgesehen. Die Kommunikationsleitung ist somit eine im Wesentlichen modulinterne Verdrahtung der Module beziehungsweise der zweiten Controller der damit bestückten Schutzschalter, zum Zwecke einer Signalisierung und/oder auch Betätigung der Schutzschalter mit dem ersten Controller. Durch die Koppelkontakte ist eine Querverdrahtung der Module untereinander bereitgestellt, wobei die Koppelkontakte im Montagezustand eine elektrisch leitfähige Kopplung in Reihenrichtung, das heißt von Gehäusestirnseite zu Gehäusestirnseite zwischen jeweils zwei benachbarten Modulen realisieren.

Die Kommunikationsleitung dient ebenfalls zur Führung eines Datenbussignals (beispielsweise des Schaltsignals) vom ersten Controller an einen oder mehrere zweite Controller, wobei die Widerstandskette insbesondere als zweite Kommunikationsleitung zur Führung eines Adressbussignals dient. Dadurch ist es beispielsweise möglich, die Schutzschalter von verschiedenen Laststromkreisen ferngesteuert zu schalten, zurückzusetzen, zu überwachen oder zu parametrisieren. Unter Parametrisierung ist in diesem Zusammenhang insbesondere das Einstellen von beispielsweise Auslöseschwellwerten und Steuer- oder Betriebsparametern, wie zum Beispiel dem Nennstrom des jeweiligen Schutzschalters, zu verstehen. Hierzu werden die Datenbussignale vom ersten Controller an den jeweiligen zweiten Controller des Schutzschalters versendet, der dazu geeignet und eingerichtet ist, derartige Signale zu verarbeiten und umzusetzen.

In einer vorteilhaften Ausgestaltung weist das Anschlussmodul eine Kontaktöffnung mit einem zweifach geteilten Stecksockelkontakt auf, in den ein Steckkontakt des Schutzschalters einsteckbar ist. Zwischen den dadurch gebildeten Stecksockelteilkontakten ist der Sockelwiderstand verschaltet. Der vorzugsweise als Flachstecker ausgeführte Steckkontakt weist hierbei zweckdienlicherweise eine zweifach geteilte Steckfahne als Steckteilkontakte auf. Dadurch ist der jeweils zweite Controller auf konstruktiv einfache und kostengünstige Art und Weise zur Erfassung der am Sockelwiderstand abfallenden Spannung anschließbar.

In einer geeigneten Ausführung weist das Anschlussmodul einen Massenanschluss auf, der einerseits mit dem jeweiligen zweiten Controller und andererseits mit einem Steckteilkontakt des Steckkontakts kontaktiert oder kontaktierbar ist. Zwischen dem Massenanschluss und dem Steckteilkontakt ist ein durch den zweiten Controller betätigbares Schaltelement geschaltet. Das Schaltelement ist bevorzugterweise in den jeweiligen Schutzschalter integriert und beispielsweise als ein Transistor ausgeführt. Durch Betätigung des Schaltelements ist es somit möglich, die Widerstandskette an der (Reihen-)Position des Steckteilkontakts gegen Masse bzw. Bezugspotential zu schalten.

Beim Betreiben des Stromverteilers wird durch den ersten Controller ein Gesamtwiderstandswert der Widerstandskette bestimmt. Anhand dieses Gesamtwiderstandswerts wird durch den ersten Controller anschließend ein der Anzahl der angeschlossenen Module entsprechender Anzahlwert bestimmt. Die Widerstandskette ist hierzu zweckdienlicherweise an einem Ende an die Gleichstromquelle des ersten Controllers, und an dem anderen Ende an eine Masse (Bezugspotential) verschaltet. Dadurch fließt durch alle Sockelwiderstände der gleiche elektrische Strom, sodass aus den bekannten Widerstandswerten der Sockelwiderstände und des Gesamtwiderstandswerts direkt die Anzahl der angeschlossenen Module bestimmbar ist. Der Gesamtwiderstandswert ist hierbei in einfacher Art und Weise durch die Ausgangsspannung der Gleichstromquelle bestimmbar.

In einer bevorzugten Weiterbildung des Verfahrens werden in Abhängigkeit der Controllersignale der angeschlossenen zweiten Controller modulspezifische Geräteadressen an die angeschlossenen zweiten Controller versendet. Die zweiten Controller erfassen durch die Steckteilkontakte die abfallende Spannung am jeweiligen Sockelwiderstand. Der erfasste Spannungswert wird als Controllersignal an den ersten Controller versendet. Die Geräteadresse wird beispielsweise als ganzzahlig (gerundeter) Quotient aus dem Spannungswert und dem Spannungsabfall eines einzelnen Sockelwiderstands bestimmt. Dadurch erhält jeder zweite Controller eine (physikalische) Geräteadresse die von der Gleichstromquelle ausgehend entlang der Widerstandskette abnimmt. Die Geräteadressen werden somit nicht anhand der Anzahl der angeschlossenen Schutzschalter vergeben, sondern anhand der Anzahl der angeschlossenen Module beziehungsweise der angeschlossenen Sockelwiderstände.

Mit anderen Worten werden bei N angeschlossenen Modulen dem zweiten Controller im Modul N (das heißt bezüglich der Gleichstromquelle an dem der Gleichstromquelle gegenüberliegenden Ende der Widerstandskette) die erste Geräteadresse, dem zweiten Controller im Modul N-1 die zweite Geräteadresse und so weiter zugeordnet, wobei der zweite Controller im ersten Modul (das heißt dem Modul am ersten Sockelwiderstand der Widerstandskette) die N-te Geräteadresse erhält. Dadurch ist eine einfache Adressierung der zweiten Controller ermöglicht. Insbesondere ist auf diese Weise eine Adressvergabe auch im Hinblick auf leere Steckplätze der Module ermöglicht, sodass Im Falle einer nachträglichen Bestückung eines Moduls mit einem Schutzschalter keine erneute Adressvergabe notwendig ist, und die zweiten Controller mit den bereits vergebenen Geräteadressen weiterarbeiten.

Im Zuge der Adressierung treibt der erste Controller mittels der Gleichstromquelle einen Strom (Adressierstrom) als ein Adressbussignal durch die Widerstandskette des Modulpakets. In einer geeigneten Ausgestaltungsform weisen die Sockelwiderstände beispielsweise einen Widerstandswert von jeweils 1 kΩ auf, sodass bei einem generierten Adressierstrom von 1 mA an jedem Sockelwiderstand eine Spannung von 1 V abfällt. Der jeweilige Spannungswert des Moduls wird hierbei geeigneterweise auf der der Gleichstromquelle zugewandten Seite des Sockelwiderstands vom jeweiligen zweiten Controller gemessen.

Im Zuge der Adressierung erfasst der dem gemeinsamen ersten Controller an erster Stelle nachgeschaltete zweite Controller den höchsten Spannungswert und gibt diesen über die Kommunikationsleitung als Controllersignal an den ersten Controller weiter. Der in der Reihenanordnung nachfolgende Schutzschalter beziehungsweise dessen zweiter Controller erfasst somit eine um 1 V verringerten Spannungswert und meldet diesen an den ersten Controller. Auf diese Weise werden jedem angeschlossenen Controller ein Spannungswert und daraus eine Geräteadresse zugeordnet.

In einer besonders benutzerfreundlichen Weiterbildung werden die modulspezifischen Geräteadressen der zweiten Controller in Abhängigkeit des Anzahlwerts in einen der Reihenfolge der aneinander gereihten Anschlussmodule entsprechenden Satz von Logikadressen umgesetzt. Dadurch wird die Reihenfolge der N Geräteadressen effektiv umgedreht, sodass dem zweiten Controller im ersten Modul hinter der Gleichstromquelle die erste Logikadresse, dem zweiten Controller im nächsten Modul die zweite Logikadresse etc. zugeordnet wird. Dadurch ist für einen Benutzer eine besonders intuitive Bedienung des Stromverteilers sichergestellt.

Bei einer galvanischen Unterbrechung der Widerstandskette wird ein Suchvorgang zur Ermittlung der Position der Unterbrechung ausgelöst beziehungsweise gestartet. Durch die Unterbrechung ist die Gleichstromquelle über die Widerstandskette nicht mehr mit Masse (Bezugspotential) verbunden (von dieser also abgetrennt), sodass kein Adressierstrom durch die Widerstandskette fließt. Der erste Controller ist einerseits durch eine Erfassung des Adressierstroms in einfacher Art und Weise dazu eingerichtet eine derartige Unterbrechung zu detektierten. Des Weiteren erfassen die angeschlossenen zweiten Controller an allen Positionen lediglich einen Spannungsabfall von 0 V, sodass eine Unterbrechung zusätzlich oder alternativ über die Controllersignale an den ersten Controller signalisiert wird.

Dadurch werden Drahtbrüche oder defekte Bauteile im Modulpaket einfach und zuverlässig erkannt. Die ermittelte Position ist anschließend vorteilhafterweise einem Benutzer zur Verfügung angezeigt oder signalisiert. Dadurch vereinfacht sich eine Wartung oder eine Reparatur des Stromverteilers. Um einen erfolgreichen Suchvorgang sicherzustellen, sind für diese Anwendung vorzugsweise alle Module des Modulpakets mit jeweils einem Schutzschalter versehen.

Zu Beginn des Suchvorgangs werden alle angeschlossenen zweiten Controller in einen Einschaltzustand versetzt, bei dem das jeweilige Schaltelement geschlossen wird. Dadurch werden die mit einem Schutzschalter versehenen Sockelwiderstände insbesondere mit dem jeweiligen Massenanschluss des Moduls verbunden. In der Folge sind alle Sockelwiderstände auf der der Gleichstromquelle abgewandten Seite gegen Masse geschaltet, und der Adressierstrom fließt von der Gleichstromquelle zur Masse.

Während des Suchvorgangs wird eine neue Adressierung gestartet. Hierzu wird vom ersten Controller der Anzahlwert für die Anzahl der angeschlossenen Module bestimmt, und Geräteadressen werden an die jeweiligen zweiten Controller verteilt. Der zweite Controller mit der ersten Geräteadresse wird anschließend abgeschaltet. In einer bevorzugten Ausführung wird der Suchvorgang beendet, wenn es keinen zweiten Controller mit der ersten Geräteadresse gibt. Dadurch ist der erste Controller in der Lage, die Position der Unterbrechung innerhalb des Modulpakets zu bestimmen.

Nachdem zu Beginn des Suchvorgangs alle Schaltelemente der Schutzschalter in den Einschaltzustand versetzt wurden, und die jeweils entsprechende Seite des Sockelwiderstands gegen Masse geschaltet ist, fällt an allen zwischen der Gleichstromquelle und der Unterbrechungsstelle befindlichen Sockelwiderständen eine Spannung (beispielsweise wiederum 1 V) ab. Befindet sich die Unterbrechung nach dem ersten Modul beziehungsweise nach dem ersten Sockelwiderstand, so meldet der dem ersten Modul zugeordnete zweite Controller die erste Geräteadresse. Daraufhin wird dessen Schaltelement ausgeschaltet, das heißt der Sockelwiderstand wird von dem Massenanschluss getrennt. Dadurch meldet sich der in der Reihe am nächsten geschaltete zweite Controller über dessen Sockelwiderstand. Daraufhin wird auch dessen Schaltelement ausgeschaltet. Dieser (Such-)Vorgang wird fortgesetzt, bis sich kein zweiter Controller mit der ersten Geräteadresse meldet. Dadurch ist die Position der Unterbrechung zwischen dem letzten erkannten zweiten Controller und dem daran angereihten, nicht erkannten Modul von dem ersten Controller bestimmt.

Der erste Controller und die zweiten Controller des erfindungsgemäßen Stromverteilers sind hierbei allgemein - programm- und/oder schaltungstechnisch - zur Durchführung des vorstehend beschriebenen erfindungsgemäßen Verfahrens eingerichtet.

Die Controller sind zumindest im Kern durch jeweils einen Mikrocontroller mit einem Prozessor und einem Datenspeicher gebildet, in dem die Funktionalität zur Durchführung des erfindungsgemäßen Verfahrens in Form einer Betriebssoftware (Firmware) programmtechnisch implementiert ist, so dass das Verfahren - gegebenenfalls in Interaktion mit einem Benutzer - bei Ausführung der Betriebssoftware in dem Mikrocontroller automatisch durchgeführt wird.

Der erste Controller und/oder die zweiten Controller sind in einer möglichen Ausführungsform im Rahmen der Erfindung alternativ aber auch durch programmierbare elektronische Bauteile, zum Beispiel einen anwendungsspezifischen integrierten Schaltkreis (ASIC) gebildet, in dem die Funktionalität zur Durchführung des erfindungsgemäßen Verfahrens mit schaltungstechnischen Mitteln implementiert ist.

Nachfolgend werden Ausführungsbeispiele der Erfindung anhand einer Zeichnung näher erläutert. Es zeigen in vereinfachten und schematischen Darstellungen:
- Fig. 1: in perspektivischer Darstellung einen Stromverteiler mit einem Einspeisemodul, mit einem Signalmodul, mit sechs dazwischen angeord-neten Anschlussmodulen, sowie mit zwei bestückten Schutzschaltern,
- Fig. 2: in perspektivischer Darstellung ein Anschlussmodul,
- Fig. 3: in perspektivischer Darstellung ein Anschlussmodul ohne Gehäuse,
- Fig. 4: in Seitendarstellung das Anschlussmodul ohne Gehäuse,
- Fig. 5: in perspektivischer Darstellung mehrere Kontaktelemente des Anschlussmoduls,
- Fig. 6: in perspektivischer Darstellung mit Blick auf eine Rückseite die Kontaktelemente mit einem dazwischengeschalteten Sockelwiderstand,
- Fig. 7: eine schematische Schaltung des Stromverteilers mit einem Controller und N daran angeschlossenen Anschlussmodulen mit jeweils einem bestückten Schutzschalter, und
- Fig. 8: ein Flussdiagramm für einen Suchvorgang des ersten Controllers im Zuge einer Fehlerdiagnose.

Einander entsprechende Teile und Größen sind in allen Figuren stets mit den gleichen Bezugszeichen versehen.

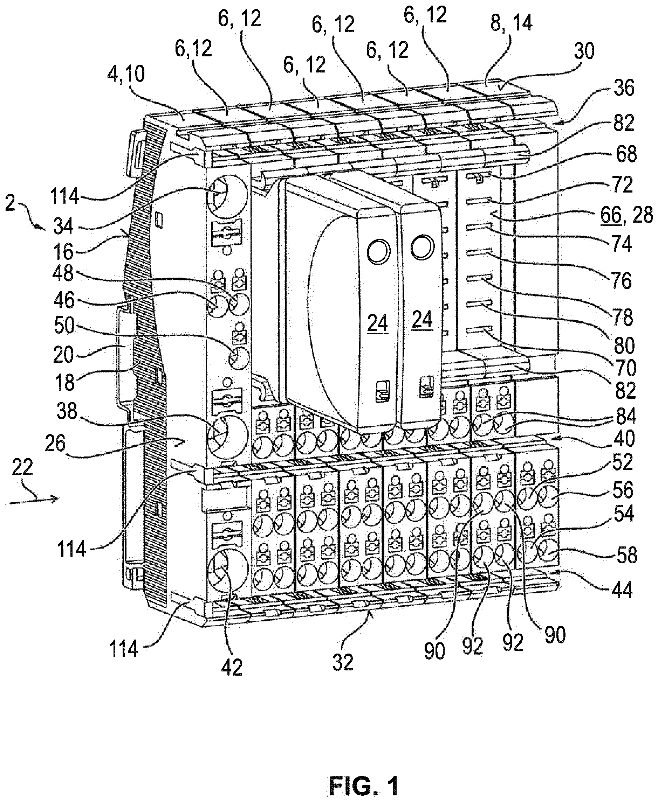

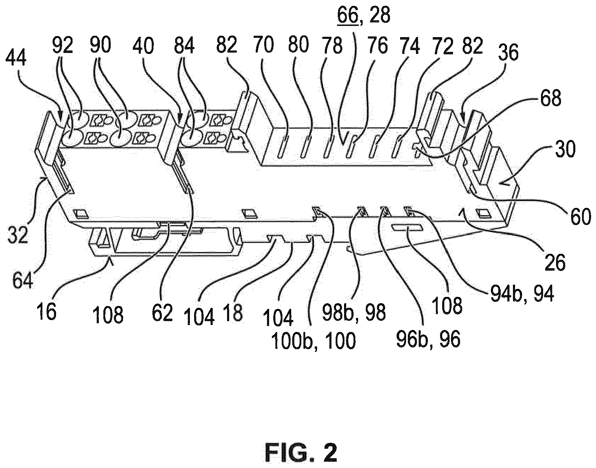

Der in Fig. 1 dargestellte Stromverteiler 2 umfasst ein Einspeisemodul 4, sechs Anschlussmodule 6 und ein Signalmodul 8 als (Stromverteilungs-)Module, wobei das Anschlussmodul 6 in Fig. 2 einzeln dargestellt ist. Jedes Modul 4, 6, 8 umfasst ein separates, das heißt von den anderen Modulen 4, 6, 8 getrenntes Gehäuse 10, 12 beziehungsweise 14. Jedes Modul 4, 6, 8 ist nach Art eines Reiheneinbaugeräts ausgebildet und weist dementsprechend an einer Gehäuserückseite 16 eine nutartige Aufnahme 18 auf, mit der das jeweilige Modul 4, 6, 8 zu Montagezwecken auf eine Tragschiene 20 aufschnappbar ist.

Die Profilrichtung dieser Aufnahme 18 - und entsprechend im Montagezustand auch die Profilrichtung der mit dieser Aufnahme 18 korrespondierenden Tragschiene 20 - definieren eine Reihenrichtung 22, entlang derer die Module 4, 6, 8 aneinander aufgereiht sind. In dem in Fig. 1 dargestellten Ausführungsbeispiel sind hierbei zwei Schutzschalter 24 an jeweils einem Anschlussmodul 6 im Inneren des aus den Modulen 4, 6, 8 gebildeten (Modul-)Pakets angeordnet, wobei das Einspeisemodul 4 einerseits und das Signalmodul 8 andererseits die Anschlussmodule 6 in Reihenrichtung 22 als Seitenteile außenseitig flankieren.

Die in Reihenrichtung 22 einander gegenüberliegenden Gehäuseflächen eines jeden Moduls 4, 6, 8 sind nachfolgend als (Gehäuse-)Stirnseiten 26 des jeweiligen Moduls 4, 6, 8 bezeichnet. Die zu der Rückseite 16 entgegengesetzte Gehäuseseite eines jeden Moduls 4, 6, 8 ist als (Gehäuse-)Frontseite 28 des Moduls 4, 6, 8 bezeichnet. Diese Frontseite 28 ist, wenn der Stromverteiler 2 in einem Schaltschrank montiert ist, einem Benutzer zugewandt. Die beiden übrigen Gehäuseseiten eines jeden Moduls 4, 6, 8 sind - entsprechend der konventionsgemäßen Einbaustellung des Moduls 4, 6, 8 - als (Gehäuse-)Oberseite 30 beziehungsweise (Gehäuse-)Unterseite 32 unabhängig von der tatsächlichen Stellung im umgebenden Raum bezeichnet.

Das Einspeisemodul 4 umfasst einen Einspeiseanschluss 34 zur elektrischen Kontaktierung an einen nicht näher dargestellten Hauptstromkreis und somit zur Einspeisung eines elektrischen Stroms in den Stromverteiler 2. Der Einspeiseanschluss 34 ist an der Frontseite 28 des Gehäuses 10 nahe der Oberseite 30 angeordnet, und als eine Anschlussklemme für einen Draht- oder Litzenleiter des Hauptstromkreises ausgestaltet. Der Einspeiseanschluss 34 ist innerhalb des Gehäuses elektrisch leitend mit einem nicht näher dargestellten Koppelkontakt gekoppelt, der innerhalb eines nutenartigen Gehäuseschlitzes 36 angeordnet ist.

Das Einspeisemodul 4 weist etwa auf halber Höhe des Gehäuses 10 einen Massenanschluss 38 als einen Minusanschluss (DC-Netz) beziehungsweise als einen Neutralleiter (AC-Netz) auf. Der Massenanschluss 38 ist innerhalb des Gehäuses 10 elektrisch leitend mit einer seitlichen Steckbuchse für eine Kontaktverbindung mit dem angereihten Anschlussmodul 6 gekoppelt, sowie mit einem Koppelkontakt der in einem mittig am Gehäuse 10 eingebrachten Gehäuseschlitz 40 an der Frontseite 28 positioniert ist.

Das Einspeisemodul 4 umfasst weiterhin einen Rückführanschluss 42 zur elektrischen Kontaktierung an eine nicht näher dargestellte Stromrückführung im Zuge einer Schutz- oder Funktionserde. Der Rückführanschluss 42 ist nahe der Unterseite 32 an der Frontseite 28 des Gehäuses 10 angeordnet, und wie der Einspeiseanschluss 34 und der Massenanschluss 38 als eine Anschlussklemme ausgeführt. Der Rückführanschluss 42 ist wiederum elektrisch leitend mit einem Koppelkontakt innerhalb eines im Bereich der Unterseite 32 angeordneten Gehäuseschlitzes 44 gekoppelt.

Die nutenartigen Gehäuseschlitze 36, 40, 44 sind insbesondere derart in das Gehäuse 10 des Einspeisemoduls 4 eingebracht, dass sie zu der Frontseite 28 hin offen sind. Die Gehäuseschlitze 36, 40, 42 erstrecken sich in Reihenrichtung 22 im Wesentlichen über die gesamte Gehäusebreite und sind somit zu den beiden gegenüberliegenden Stirnseiten 26 des Gehäuses 10 hin offen.

Zwischen dem Einspeiseanschluss 34 und dem Massenanschluss 38 sind gehäusefrontseitig drei weitere Anschlussklemmen für einen Signalanschluss 46, für einen Datenbusanschluss 48 und für einen Adressbusanschluss 50 vorgesehen. Die Anschlüsse 46, 48, 50 sind im Vergleich zu den Anschlüssen 34, 38, 42 verkleinert ausgeführt, und vorzugsweise für die Einspeisung von Niederströmen als Schalt- beziehungsweise Kommunikationssignalen ausgestaltet. Die Anschlüsse 46, 48, 50 sind ähnlich zu dem Massenanschluss 38 innerhalb des Gehäuses 10 mit jeweils einer seitlichen Steckbuchse zur Kontaktierung mit dem Anschlussmodul 6 gekoppelt.

Das Gehäuse 14 des Signalmoduls 8 weist drei Gehäuseschlitze 36, 40, 44 auf, die im Wesentlichen identisch zu denen des Einspeisemoduls 4 ausgestaltet sind, jedoch keine Koppelkontaktierung mit dem Gehäuseinneren aufweisen. Zwischen den unteren Gehäuseschlitzen 40 und 44 sind vier Anschlussklemmen 52, 54, 56 und 58 als ein Massenanschluss 52, ein Signalanschluss 54, ein Datenbusanschluss 56 und ein Adressbusanschluss 58 angeordnet.

Die Anschlüsse 52, 54, 56, 58 sind innerhalb des Gehäuses 14 mit Kontaktelementen zur Koppelkontaktierung mit dem Anschlussmodul 6 gekoppelt. Die flachsteckerartigen Kontaktelemente ragen aus der im Montagezustand einem Anschlussmodul 6 zugewandten Stirnseite 26 zumindest teilweise aus dem Gehäuse 14 heraus.

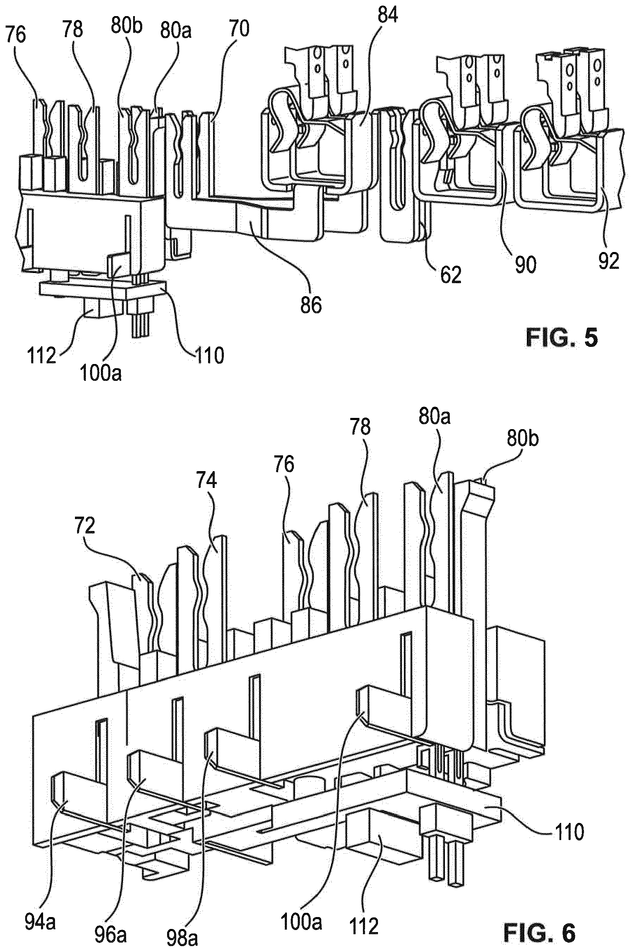

Anhand der Figuren 2 bis 6 ist im Nachfolgenden der Aufbau eines Anschlussmoduls 6 näher erläutert, wobei beispielhaft in der Fig. 1 lediglich ein Anschlussmodul 6 mit Bezugszeichen versehen ist. Das Gehäuse 12 des Anschlussmoduls 6 weist drei Gehäuseschlitze 36, 40 und 44 auf, die im Wesentlichen identisch zu denen des Einspeisemoduls 4 ausgestaltet sind, mit jeweils einem Koppelkontakt 60, 62, 64 im Gehäuseinneren. Zwischen den Gehäuseschlitzen 36 und 40 ist ein frontseitiger Steckplatz 66 für den Schutzschalter 24 angebracht. Der Steckplatz 66 weist eine erste Kontaktöffnung 68 für einen (bevorzugt als Flachstecker ausgebildeten) ersten Steckkontakt des Schutzschalters 24 sowie eine zweite Kontaktöffnung 70 für einen (bevorzugt ebenfalls als Flachstecker ausgebildeten) zweiten Steckkontakt des Schutzschalters 24.

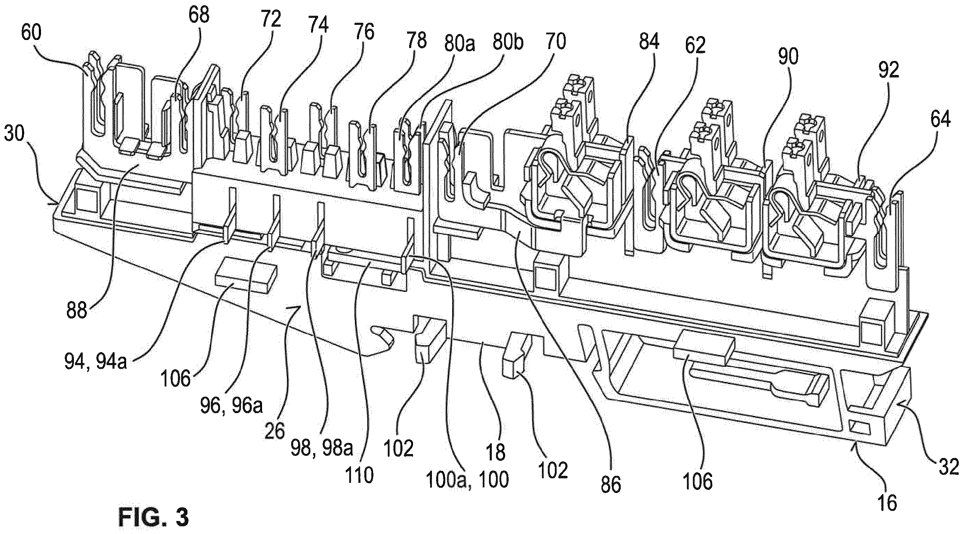

Der Steckplatz 66 ist außerdem mit fünf weiteren Kontaktöffnungen 72, 74, 76, 78 und 80 für (bevorzugt als Flachstecker ausgebildete) korrespondierende Signal- oder Kommunikationskontakte des Schutzschalters versehen. Wie insbesondere in den Figuren 3 bis 6 ersichtlich sind die Kontaktöffnungen 68, 70, 72, 74, 76, 78, 80 des Steckplatzes 66 insbesondere als Stecksockelkontakte ausgeführt. Die Kontaktöffnungen oder Stecksockelkontakte 68, 70, 72, 74, 76, 78, 80 und die entsprechenden Steckkontakte des Schutzschalters 24 sind insbesondere im Sinne von Stecker-Buchsen-Paaren zueinander komplementär ausgestaltet.

Der Steckplatz 66 weist weiterhin im oberen und unteren Bereich jeweils ein hakenähnliches Haltelement 82 zur verbesserten Halterung eines bestückten Schutzschalters 24 auf. Unterhalb des Steckplatzes 66 sind zwei Anschlussklemmen als Lastanschlüsse 84 zum Anschluss eines nicht näher dargestellten Verbraucher- oder Laststromkreises angeordnet. Die Lastanschlüsse 84 sind gehäuseintern mit der Kontaktöffnung 70 elektrisch leitfähig durch eine Leiterschiene 86 gekoppelt. Weiterhin ist die Kontaktöffnung 68 im Inneren des Gehäuses 12 mit dem Koppelkontakt 60 des Gehäuseschlitzes 36 im Wesentlichen einstückig mittels einer elektrisch leitfähigen Leiterschiene 88 gekoppelt. Somit ist der Schutzschalter 24 im Montagezustand zwischen dem Koppelkontakt 60 und den Lastanschlüssen 84 zur Unterbrechung des Laststromkreises verschaltet.

Das Anschlussmodul 6 umfasst ferner vier Anschlussklemmen 90, 92, die zwischen den unteren Gehäuseschlitzen 40, 44 als zwei Massenanschlüsse 92 und zwei Rückführanschlüsse 90 angeordnet sind. Im Inneren des Gehäuses 12 sind die Massenanschlüsse 92 an jeweils einen Koppelkontakt 64 des Gehäuseschlitzes 44 und die Rückführanschlüsse 90 an jeweils einen Koppelkontakt 62 des Gehäuseschlitzes 40 elektrisch leitfähig angebunden.

Die Stecksockelkontakte 70, 72, 74, 76, 78 sind gehäuseintern an vier Koppelkontakte 94, 96, 98 und 100 elektrisch leitfähig gekoppelt. Die Koppelkontakte 94, 96, 98, 100 sind insbesondere als Stecker-Buchsen-Paare ausgeführt, wobei die Stecker im Nachfolgenden den Bezugszeichenzusatz -a und die Buchsen den Bezugszeichenzusatz -b aufweisen. Die Steckbuchsen 94b, 96b, 98b, 100b sind in stirnseitigen Gehäuseöffnungen angeordnet, wobei die Stecker 94a, 96a, 98a, 100a zumindest teilweise - wie insbesondere in Fig. 3 ersichtlich - aus der gegenüberliegenden Stirnseite 26 des Gehäuses 12 herausragen.

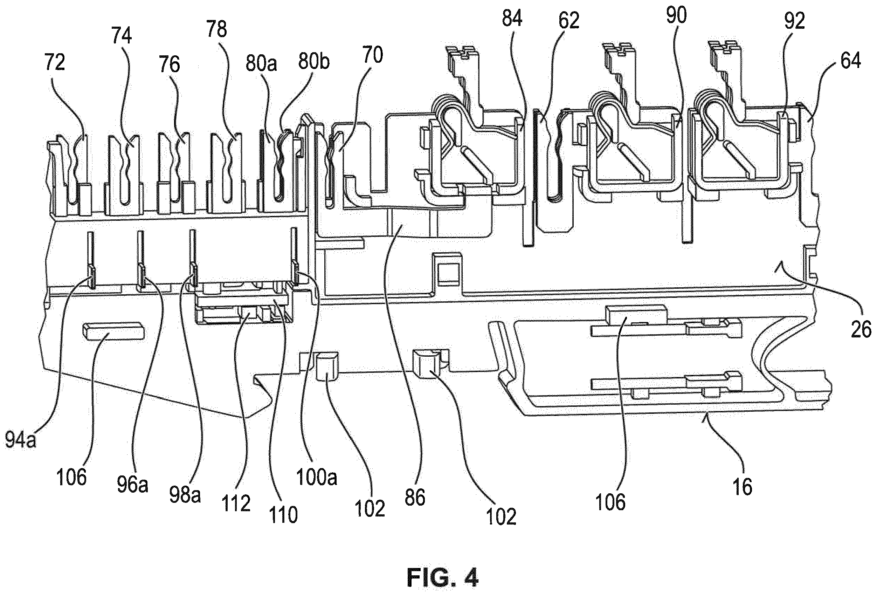

Die Gehäuse 12 der Anschlussmodule 6 weisen - wie in Fig. 3 und Fig. 4 deutlich ist - auf der Rückseite 16 im Bereich der Aufnahme 18 zwei Rastzungen 102 auf, die der jeweiligen Stirnseite 26 seitlich überstehen. Die Rastzungen 102 sind zum Zwecke einer erleichterten Montage der Module 4, 6, 8 mit entsprechenden Rastaufnahmen 104 verrast- beziehungsweise verklipsbar, wobei die Rastaufnahmen 104 zweckdienlicherweise auf der gegenüberliegenden Stirnseite 26 zu den Rastzungen 102 angeordnet sind. Die Gehäuse 12 weisen weiterhin auf der rastzungenseitigen Stirnseite 26 zwei angeformte und der Stirnseite 26 überstehende Fügefortsätze 106 zum erleichterten Aneinanderreihen beziehungsweise Aneinanderstecken der Module 4, 6, 8 auf. Die Fügefortsätze 106 greifen im Montagezustand zumindest teilweise in entsprechende Fügeaufnahmen 108 der benachbarten Module 4, 6 zum Zwecke einer rüttelfesten und betriebssicheren Befestigung ein.

Wie insbesondere in den Figuren 3, 5 und 6 deutlich wird ist die stecksockelartige Kontaktöffnung 80 insbesondere als ein zweifach geteilter Stecksockelkontakt ausgeführt. Die dadurch gebildeten Stecksockelteilkontakte 80a, 80b sind mittels einer rückseitig zu den Kontaktöffnungen 68, 70, 72, 74, 76, 78 80 angeordneten Platine 110 gekoppelt. Zwischen den Stecksockelteilkontakten 80a, 80b ist auf der Platine 110 ein Sockelwiderstand 112 verschaltet. Der Sockelwiderstand 112 ist in Reihe zwischen den Koppelkontakten 100a und 100b geschaltet, und die Platine 110 an die Koppelkontakte 98a, 98b angeschlossen.

Zur Montage des Stromverteilers 2 wird ein Einspeisemodul 4 mit einer Anzahl anzuschließender Laststromkreise entsprechenden Zahl von Anschlussmodulen 6 und einem Signalmodul 8 gemäß Fig. 1 stirnseitig aneinandergereiht. Dabei werden die Module 6, 8 durch Rastzungen 102 an den Stirnseiten 26 jedes Gehäuses 12, 14 mit entsprechenden Rastaufnahmen 104 der Module 4, 6 an der Stirnseite des jeweils benachbarten Moduls 4, 6, 8 fluchtend und lösbar miteinander (steck-)verbunden. Die Stirnseiten 26 der Anschlussmodule 6 werden somit von dem Einspeisemodul 4, benachbarten Anschlussmodulen 6 sowie dem Signalmodul 8 im Wesentlichen vollständig abgedeckt. Wie insbesondere in Fig. 1 deutlich wird, fluchten die Gehäuseschlitze 36, 40 und 44 der benachbarten Module 4, 6, 8 ineinander, sodass jeweils eine im Wesentlichen durchgängige und geradlinige nutenartige Durchsetzung der Module 4, 6, 8 realisiert ist.

Im Rahmen eines derartigen Stromverteilers 2 wird der Einspeiseanschluss 34 des Einspeisemoduls 4 mit den aneinandergereihten Modulen 6 parallel geschaltet, indem eine nicht näher dargestellte Stromschiene in die fluchtenden Gehäuseschlitze 36 eingedrückt, und so mit den entsprechenden Koppelkontakten 60 kontaktiert wird. Die Stromschiene ist hierbei hinsichtlich ihrer Länge derart bemessen, dass sie sich über die Gesamtbreite aller in den Stromverteiler 2 zu integrierenden Module 4, 6, 8 erstreckt. Der Anschluss der somit parallel geschalteten Module 4, 6, an eine externe Stromquelle erfolgt hierbei durch konventionelle Verdrahtung des Hauptstromkreises mit der Anschlussklemme des Einspeiseanschlusses 34.

Ebenso werden die Masseanschlüsse 38, 52, 90 sowie die Rückführanschlüsse 42, 92 der angereihten Module 4, 6 durch Eindrücken jeweils einer weiteren Stromschiene in den Gehäuseschlitzen 40 und 44 einander parallel geschaltet, wobei der Masseanschluss 38 insbesondere mit einem Minusleiter oder Neutralleiter und der Rückführanschluss 42 insbesondere mit einer Schutz- oder Funktionserde als Rückführpotential angeschlossen werden. Die einzelnen Laststromkreise des Stromverteilers 2 werden anschließend an jeweils ein zugeordnetes Anschlussmodul 6 angeschlossen, indem die jeweiligen Zuführleitungen des Laststromkreises mit den Lastanschlüssen 84 der Anschlussmodule 6, und die Rückführleitung des Laststromkreises mit den Anschlussklemmen der Rückführanschlüsse 90 der Anschlussmodule 6 elektrisch leitfähig verbunden werden.

Um die Gehäuseschlitze 36, 40, 44 der Module 4, 8 zu den in Reihenrichtung 22 jeweils außenliegenden Stirnseiten 26 berührungssicher abzuschließen, ist jeder Gehäuseschlitz 36, 40, 44 - wie in Fig. 1 für das Einspeisemodul 4 dargestellt - außenseitig mit einem isolierenden Abdeckelement 114 versehen.

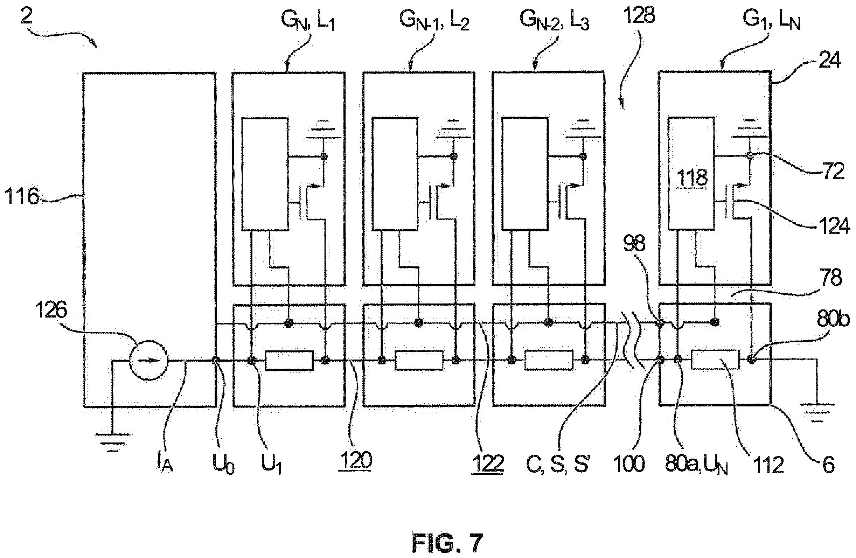

Zum Betrieb des Stromverteilers 2 ist ein externer Controller 116 als eine Steuereinheit vorgesehen, der mit den Datenbusanschluss 48 und den Adressbusanschluss 50 an das Einspeisemodul 4 angeschlossen wird. Bevorzugterweise weisen die Schutzschalter 24 schalterintern jeweils einen Controller 118 auf, der im Montagezustand signaltechnisch an den Controller 116 angebunden ist. Die Verschaltung der Controller 116, 118 im Zuge einer Bus-Funktionalität ist schematisch und in vereinfachter Form in Fig. 7 dargestellt.

Fig. 7 zeigt einen allgemeinen Stromverteiler 2 mit N aneinandergereihten Anschlussmodulen 6, wobei zur Vereinfachung das Einspeisemodul 4 und das Signalmodul 8 des Stromverteilers 2 nicht dargestellt sind. Die N Anschlussmodule 6 sind in dem dargestellten Ausführungsbeispiel jeweils mit einem Schutzschalter 24 umfassend den Controller 118 bestückt. Wie in der Fig. 7 vergleichsweise deutlich ersichtlich wird sind die Sockelwiderstände 112 der angereihten Anschlussmodule 6 durch die Koppelkontakte 100 in Reihe geschalten, und bilden eine im Wesentlichen durchgängige Widerstandskette 120 zwischen den Adressbusanschlüssen 50 und 58.

Der Schutzschalter 24 ist mit einem zweigeteilten Steckkontakt derart mit dem Stecksockelkontakt 80 kontaktiert, dass der Controller 118 des Schutzschalters 24 über die Stecksockelteilkontakte 80a, 80b im Wesentlichen parallel zum Sockelwiderstand 112 geschalten ist. Über die Kontaktöffnung 76 ist der Controller 118 an eine durch die Koppelkontakte 98 gebildete Datenbusleitung oder Kommunikationsleitung 122 angeschlossen. Der Stecksockelteilkontakt 80b ist schalterintern mit dem Stecksockelkontakt 72 verschaltet, wobei der Stecksockelkontakt 72 über die Koppelkontakte 94 insbesondere mit dem Massenanschluss 38 des Einspeisemoduls 4 elektrisch leitfähig gekoppelt ist. Zwischen den Stecksockelkontakten 80b, 72 ist im Schutzschalter 24 ein durch den Controller 118 gesteuerter Transistor als ein Schaltelement 124 verschaltet. Beispielhaft ist in der Fig. 7 lediglich das N-te Anschlussmodul 6 mit dem Schutzschalter 24 mit Bezugszeichen versehen.

Der Controller 116 weist controllerintern eine Gleichstromquelle 126 zur Bestromung der Widerstandskette 120 mit einem Adressierstrom I_{A} auf. Im Betrieb fließt somit durch die Widerstandskette 120 der Adressierstrom I_{A}, sodass an allen Sockelwiderständen eine jeweilige Spannung Uᵢ abfällt, wobei der Laufindex i von 1 bis N gewählt ist. Der Controller 116 ist dazu geeignet und eingerichtet die Anzahl N der angeschlossenen Anschlussmodule 6 anhand eines Anzahlwerts A zu bestimmen. Hierzu erfasst der Controller 116 eine Ausgangsspannung U₀ der Gleichstromquelle 126. Bei einem bekannten Adressierstrom I_{A} und bekannten Wert des elektrischen Widerstands eines einzelnen Sockelwiderstandes 112, ergibt sich der Anzahlwert A in einfacher Art und Weise aus dem Quotienten der Ausgangsspannung U₀ und dem Spannungsabfall an einem einzelnen Sockelwiderstand 112.

Jeder Controller 118 erfasst im Betrieb über den Stecksockelteilkontakt 80a den modulspezifischen Spannungswert Uᵢ, wobei der Spannungswert Uᵢ mit zunehmender Länge der Widerstandskette 120 zwischen zwei Anschlussmodulen 6 stets um einen Spannungsabfall am jeweiligen Sockelwiderstand 112 reduziert wird. Die Controller 118 versenden über die Datenbusleitung 122 ein der jeweiligen Spannung Uᵢ entsprechendes Controllersignal C an den Controller 116.

Der Controller 116 ordnet jedem angeschlossenen Controller 118 anhand der empfangenen Controllersignale C eine Geräteadresse Gᵢ zu. Die jeweilige Geräteadresse Gᵢ ergibt sich hierbei beispielsweise in einfacher Art und Weise aus dem ganzzahlig gerundeten Quotienten aus der jeweils erfassten Spannung Uᵢ und dem Spannungsabfall an einem einzelnen Sockelwiderstand 112. Dadurch wird jedem Schutzschalter 24 beziehungsweise jedem Controller 118 eine (physikalische) Geräteadresse Gᵢ zugeordnet, die ausgehend von der Gleichstromquelle 126 entlang der Widerstandskette 120 abnimmt. An dem N-ten Anschlussmodul 6 am Ende der Widerstandskette 120 ist die Spannung U_{N} gleich dem Spannungsabfall an dem Sockelwiderstand 112, das heißt, dass dem N-ten Anschlussmodul 6 die erste Geräteadresse G₁ zugeordnet wird. Entsprechend erhält das erste Anschlussmodul 6 der Widerstandskette 120 die N-te Geräteadresse G_{N}, da die erfasste Spannung U₁ im Wesentlichen gleich der Ausgangsspannung U₀ der Gleichstromquelle 126 ist. Die Geräteadresse G_{N} wird von dem Controller 116 an den jeweiligen Controller 118 versendet und in einem zugeordneten Datenspeicher des Controllers 118 hinterlegt.

Der Controller 116 ist zum Zwecke einer verbesserten Bedienbarkeit dazu geeignet und eingerichtet einen Mappingprozess auszuführen, der den Satz von Geräteadressen Gᵢ in einen der Reihenfolge der aneinander gereihten Anschlussmodule 6 entsprechenden Satz von Logikadressen Lᵢ umzusetzen. Die Logikadressen Lᵢ sind in ihrer Reihenfolge in Bezug auf die Geräteadressen im Wesentlichen invertiert, das heißt, dass der Controller 118 des ersten Anschlussmoduls 6 in der Widerstandskette 120 die erste Logikadresse L₁ aufweist, der darauffolgende Controller 118 die zweite Logikadresse L₂ etc. sowie der letzte Controller 118 des am Ende der Widerstandskette 120 angeordneten Anschlussmoduls 6 die N-te Logikadress L_{N} aufweist. Dadurch wird die Benutzung des Stromverteilers 2 für einen Benutzer intuitiver gestaltet.

Der Controller 116 ist erfindungsgemäß dazu geeignet und eingerichtet im Fehlerfall selbsttätig eine Fehlerdiagnose zu starten. Unter einem Fehlerfall wird in diesem Zusammenhang insbesondere eine galvanische Unterbrechung 128 der Widerstandskette 120 verstanden, die in Fig. 7 lediglich beispielhaft zwischen dem dritten Anschlussmodul 6 und dem N-ten Anschlussmodul 6 angedeutet ist.

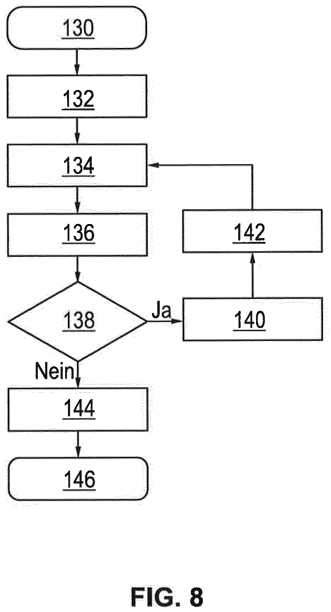

Der Ablauf der Fehlerdiagnose wird im Nachfolgenden anhand des in Fig. 8 dargestellten Flussdiagramms erläutert.

Im Falle einer Unterbrechung 128 ist der Stromfluss des Adressierstroms I_{A} durch die Widerstandskette 120 unterbrochen. Der Controller 116 löst daraufhin in einem ersten Verfahrensschritt 130 einen Suchvorgang aus. Zu Beginn eines derartigen Suchvorgangs wird zunächst ein Einschaltprozess 132 gestartet. Bei dem Einschaltprozess 132 versendet der Controller 116 über die Datenbusleitung 122 ein Schaltsignal S an alle angeschlossenen Controller 118. Bei einem Empfang des Schaltsignals S schließt der jeweilige Controller 116 das jeweils zugeordnete Schaltelement 124, sodass die Widerstandskette 120 jeweils über den Stecksockelteilkontakt 80b und den Stecksockelkontakt 72 gegen Masse geschaltet ist. Dadurch fließt ein Adressierstrom I_{A} durch die Widerstandskette 120 zur Masse.

Nach dem Einschaltprozess 132 wird in einem Detektionsprozess 134 die Anzahl der angeschlossenen Anschlussmodule 6 durch Bestimmung des Anzahlwerts A vom Controller 116 erfasst. In einem anschließenden Adressierprozess 136 werden die Geräteadressen Gᵢ vom Controller 116 an die angeschlossenen Controller 118 zugeteilt und versendet. Als nächstes werden während einer Abfrage 138 die jeweiligen Geräteadressen Gᵢ von den Controllern 118 als Controllersignale C an den Controller 116 versendet, wobei der Controller 116 überprüft, ob die erste Geräteadresse G₁ vorhanden ist.

Wird ein Controller 116 mit der Geräteadresse G₁ detektiert, so wird von dem Controller 116 ein Abschaltprozess 140 gestartet, bei dem der Controller 116 ein Schaltsignal S' an den Controller 118 mit der Geräteadresse G₁ versendet. Beim Empfang des Schaltsignals S' schaltet der Controller 118 sein zugeordnetes Schaltelement 124 aus, sodass der jeweilige Sockelwiderstand 112 am Stecksockelteilkontakt 80b nicht länger gegen Masse geschaltet ist. Dadurch wird der jeweilige Sockelwiderstand 112 aus dem Verbund der Widerstandskette herausgelöst, und der Adressierstrom I_{A} fließt über den in der Reihe davor geschalteten Sockelwiderstand 112 zur Masse. Anschließend löscht der jeweilige Controller 118 in einem Löschprozess 142 die in dem (Daten-)Speicher des Controllers 118 hinterlegte erste Geräteadresse G₁ und ein neuer Detektionsprozess 132 des Controllers 116 wird gestartet.

Die Verfahrensschritte des Suchprozess aus Detektionsprozess 134, Adressierprozess 136, Abfrage 138, Abschaltprozess 140 und Löschprozess 142 werden solange wiederholt, bis die Controller 118 keine erste Geräteadresse G₁ an den Controller 116 melden. Danach wird der Suchvorgang mit einem Endprozess 144 abgeschlossen. Der Controller 116 meldet in einem Ergebnisprozess 146, dass die Unterbrechung 128 zwischen dem zuletzt erkannten Controller 116 und dem nicht mehr erkannten Anschlussmodul 6 lokalisiert ist.

In einer geeigneten Dimensionierung weisen die Sockelwiderstände 112 beispielsweise alle einen Widerstandswert von 1 kΩ auf, sodass bei einem generierten Adressierstrom I_{A} von vorzugsweise 1 mA an jedem Sockelwiderstand 112 eine Spannung Uᵢ von 1 V abfällt.

### Bezugszeichenliste

- 2: Stromverteiler
- 4: Einspeisemodul
- 6: Anschlussmodul
- 8: Signalmodul
- 10: Gehäuse
- 12: Gehäuse
- 14: Gehäuse
- 16: Gehäuserückseite
- 18: Aufnahme
- 20: Tragschiene
- 22: Reihenrichtung
- 24: Schutzschalter
- 26: Gehäusestirnseite
- 28: Gehäusefrontseite
- 30: Gehäuseoberseite
- 32: Gehäuseunterseite
- 34: Einspeiseanschluss
- 36: Gehäuseschlitz
- 38: Massenanschluss
- 40: Gehäuseschlitz
- 42: Rückführanschluss
- 44: Gehäuseschlitz
- 46: Signalanschluss
- 48: Datenbusanschluss
- 50: Adressbusanschluss
- 52: Massenanschluss
- 54: Signalanschluss
- 56: Datenbusanschluss
- 58: Adressbusanschluss
- 60: Koppelkontakt
- 62: Koppelkontakt
- 64: Koppelkontakt
- 66: Steckplatz
- 68: Kontaktöffnung/Stecksockelkontakt
- 70: Kontaktöffnung/Stecksockelkontakt
- 72: Kontaktöffnung/Stecksockelkontakt
- 74: Kontaktöffnung/Stecksockelkontakt
- 76: Kontaktöffnung/Stecksockelkontakt
- 78: Kontaktöffnung/Stecksockelkontakt
- 80: Kontaktöffnung/Stecksockelkontakt
- 80a, 80b: Stecksockelteilkontakt
- 82: Haltelement
- 84: Lastanschluss
- 86: Leiterschiene
- 88: Leiterschiene
- 90: Rückführanschluss
- 92: Massenanschluss
- 94: Koppelkontakt
- 94a: Stecker
- 94b: Steckbuchse
- 96: Koppelkontakt
- 96a: Stecker
- 96b: Steckbuchse
- 98: Koppelkontakt
- 98a: Stecker
- 98b: Steckbuchse
- 100: Koppelkontakt
- 100a: Stecker
- 100b: Steckbuchse
- 102: Rastzunge
- 104: Rastaufnahme
- 106: Fügefortsatz
- 108: Fügeaufnahme
- 110: Platine
- 112: Sockelwiderstand
- 114: Abdeckelement
- 116: Controller
- 118: Controller
- 120: Widerstandskette
- 122: Datenbusleitung/Kommunikationsleitung
- 124: Schaltelement/Transistor
- 126: Gleichstromquelle
- 128: Unterbrechung
- 130: Verfahrensschritt
- 132: Einschaltprozess
- 134: Detektionsprozess
- 136: Adressierprozess
- 138: Abfrage
- 140: Abschaltprozess
- 142: Löschprozess
- 144: Endprozess
- 146: Ergebnisprozess

- S, S': Schaltsignal
- i: Laufindex
- Gᵢ: Geräteadresse
- Lᵢ: Logikadresse
- A: Anzahlwert
- C: Controllersignal
- Uᵢ: Spannung
- U₀: Ausgangsspannung

## Patentansprüche

1. Verfahren zum Betreiben eines Stromverteilers (2) mit einem ersten Controller (116) und mit einer Anzahl von angereihten Anschlussmodulen (6) modulintern jeweils einem Sockelwiderstand (112), der mit den Sockelwiderständen (112) der angereihten Anschlussmodule (6) eine in Reihe geschaltete Widerstandskette (120) bildet,
- wobei die Anschlussmodule (6) jeweils mit einem betätigbaren Schutzschalter (24) mit schalterintern einem zweiten Controller (118) und mit einem Schaltelement (124) bestückt sind, welcher ein der am jeweiligen Sockelwiderstand (112) abfallenden Spannung (Uᵢ) entsprechendes Controllersignal (C) an den ersten Controller (116) sendet,
- wobei ein Gesamtwiderstandswert der Widerstandskette (120) und anhand des Gesamtwiderstandswerts ein der Anzahl der angeschlossenen Anschlussmodule (6) entsprechender Anzahlwert (A) vom ersten Controller (116) bestimmt wird,
- wobei bei einer galvanischen Unterbrechung (128) der Widerstandskette (120) ein Suchvorgang zur Ermittlung der Position der Unterbrechung (128) ausgelöst wird,
- wobei zu Beginn des Suchvorgangs alle angeschlossenen zweiten Controller (118) in einen Einschaltzustand versetzt werden, bei dem das jeweilige Schaltelement (124) geschlossen wird, und
- wobei während des Suchvorgangs der Anzahlwert (A) für die Anzahl der angeschlossenen Anschlussmodule (6) bestimmt wird,
- wobei Geräteadressen (Gᵢ) an die angeschlossenen zweiten Controller (118) verteilt werden, und
- wobei der zweite Controller (118) mit der ersten Geräteadresse (G₁), und das zugeordnete Schaltelement (124) abgeschaltet werden.

2. Verfahren nach Anspruch 1, wobei in Abhängigkeit der Controllersignale (C) der zweiten Controller (118) modulspezifische Geräteadressen (Gᵢ) an die angeschlossenen zweiten Controller (118) versendet werden.

3. Verfahren nach Anspruch 2, wobei die Geräteadressen (Gᵢ) in Abhängigkeit des Anzahlwerts (A) in einen der Reihenfolge der aneinander gereihten Anschlussmodule (6) entsprechenden Satz von Logikadressen (Lᵢ) umgesetzt werden.

4. Verfahren nach Anspruch 2 oder 3, wobei der Suchvorgang beendet wird, wenn es keinen zweiten Controller (118) mit der ersten Geräteadresse (G₁) gibt.

5. Stromverteiler (2) mit einem ersten Controller (116) und mit einer Anzahl von daran angeschlossenen Anschlussmodulen (6) zur Montage auf einer Tragschiene (20),
- wobei jedes Anschlussmodul (6) eine Anzahl seitlicher Koppelkontakte (94, 96, 98, 100) zur elektrischen und/oder signaltechnischen Kontaktverbindung mit mindestens einem an das jeweilige Anschlussmodul (6) angereihten oder anreihbaren weiteren Anschlussmodul (6) aufweist,
- wobei modulintern zwischen zwei Koppelkontakten (100a, 100b) jeweils ein Sockelwiderstand (112) derart verschaltet ist, dass die Sockelwiderstände (112) der aneinandergereihten Anschlussmodule (6) eine in Reihe geschaltete Widerstandskette (120) bilden,
- wobei die Anschlussmodule (6) jeweils mit einem betätigbaren Schutzschalter (24) bestückt oder bestückbar sind,
- wobei die Schutzschalter (24) jeweils einen schalterinternen zweiten Controller (118) zur Erfassung einer an den jeweils zugeordneten Sockelwiderstand (112) abfallenden Spannung (Uᵢ), und ein durch den zweiten Controller (118) betätigbares Schaltelement (124) aufweisen, welches zwischen dem Sockelwiderstand (112) und einem Masseanschluss (72) des Anschlussmoduls (6) verschaltet oder verschaltbar ist,
- wobei die zweiten Controller (118) in Abhängigkeit von der erfassten Spannung (Uᵢ) ein Controllersignal (C) an den ersten Controller (116) versenden,
- wobei der erste Controller (116) eine Gleichstromquelle (126) zur Versorgung der Widerstandskette (120) aufweist, und
- wobei der erste Controller (116) und die zweiten Controller (118) programm- und/oder schaltungstechnisch zur Durchführung des Verfahrens nach einem der Ansprüche 1 bis 4 eingerichtet sind.

6. Stromverteiler (2) nach Anspruch 5,
wobei zur Führung der Controllersignale (C) eine durch die Koppelkontakte (98a, 98b) gebildete Kommunikationsleitung (122) vorgesehen ist.

7. Stromverteiler (2) nach Anspruch 5 oder 6,
- wobei das Anschlussmodul (6) eine Kontaktöffnung (80) mit einem zweifach geteilten Stecksockelkontakt für einen Steckkontakt des Schutzschalters (24) aufweist, und
- wobei der Sockelwiderstand (112) zwischen den dadurch gebildeten Stecksockelteilkontakten (80a, 80b) verschaltet ist.

8. Stromverteiler (2) nach Anspruch 7,
- wobei der Massenanschluss (72) einerseits mit dem jeweiligen zweiten Controller (118) und andererseits mit einem Steckteilkontakt des Stecckontakts kontaktiert oder kontaktierbar ist, und
- wobei das Schaltelement (124) zwischen dem Massenanschluss (72) und dem Steckteilkontakt geschaltet ist.

## Claims

1. Method for operating a power distributor (2) having a first controller (116) and having a number of connection modules (6) in a row inside the module each with one base resistor (112) which forms a series-connected resistor chain (120) with the base resistors (112) of the connection modules (6) in a row,
- wherein the connection modules (6) are each equipped with an actuatable circuit breaker (24) having a second controller (118) inside the breaker and having a switching element (124), which circuit breaker transmits a controller signal (C), which corresponds to the voltage (Uᵢ) dropped across the respective base resistor (112), to the first controller (116),
- wherein a total resistance value of the resistor chain (120) is determined, and, on the basis of the total resistance value, a number value (A) corresponding to the number of connected connection modules (6) is determined by the first controller (116),
- wherein, in the event of a galvanic interruption (128) of the resistor chain (120), a search process for determining the position of the interruption (128) is initiated,
- wherein, at the beginning of the search process, all connected second controllers (118) are set to an ON state, in which the respective switching element (124) is closed, and
- wherein, during the search process, the number value (A) for the number of connected connection modules (6) is determined,
- wherein device addresses (Gᵢ) are distributed to the connected second controllers (118), and
- wherein the second controller (118) with the first device address (G₁) and the associated switching element (124) are switched off.

2. Method according to Claim 1, wherein, on the basis of the controller signals (C) of the second controllers (118), module-specific device addresses (Gᵢ) are transmitted to the connected second controllers (118).

3. Method according to Claim 2, wherein, on the basis of the number value (A), the device addresses (Gᵢ) are converted into a set of logical addresses (Lᵢ) corresponding to the order of the connection modules (6) in a row.

4. Method according to Claim 2 or 3, wherein the search process is terminated when there is no second controller (118) with the first device address (G₁).

5. Power distributor (2) having a first controller (116) and having a number of connection modules (6) which are connected to the first controller and are intended to be mounted on a supporting rail (20),
- wherein each connection module (6) has a number of lateral coupling contacts (94, 96, 98, 100) for the electrical and/or signalling contact connection to at least one further connection module (6) which is or can be in a row with the respective connection module (6),
- wherein, inside the module, a base resistor (112) is connected between two coupling contacts (100a, 100b) in each case such that the base resistors (112) of the connection modules (6) in a row form a series-connected resistor chain (120),
- wherein the connection modules (6) are each equipped or can be equipped with an actuatable circuit breaker (24),
- wherein the circuit breakers (24) each have a breaker-internal second controller (118) for capturing a voltage (Uᵢ) dropped across the respective, associated base resistor (112) and a switching element (124) which can be actuated by the second controller (118) and is connected or can be connected between the base resistor (112) and an earth connection (72) of the connection module (6),
- wherein the second controllers (118) transmit a controller signal (C) to the first controller (116) on the basis of the captured voltage (Uᵢ),
- wherein the first controller (116) has a DC power source (126) for supplying the resistor chain (120), and
- wherein the first controller (116) and the second controllers (118) are set up, in terms of programming and/or circuitry, to carry out the method according to one of Claims 1 to 4.

6. Power distributor (2) according to Claim 5, wherein, for guiding the controller signals (C), a communication line (122) formed by the coupling contacts (98a, 98b) is provided.

7. Power distributor according to Claim 5 or 6,
- wherein the connection module (6) has a contact opening (80) with a plug base contact which is divided into two for a plug contact of the circuit breaker (24), and
- wherein the base resistor (112) is connected between the partial plug base contacts (80a, 80b) formed thereby.

8. Power distributor (2) according to Claim 7,
- wherein the earth connection (72) is in contact or can be in contact with the respective second controller (118), on the one hand, and, on the other hand, is in contact or can be in contact with a partial plug contact of the plug contact, and
- wherein the switching element (124) is connected between the earth connection (72) and the partial plug contact.

## Revendications

1. Procédé de fonctionnement d'un coffret de distribution électrique (2) comprenant un premier contrôleur (116) et comprenant un certain nombre de modules de raccordement (6) juxtaposés ayant respectivement une résistance de socle (112) interne au module qui, avec les résistances de socle (112) des modules de raccordement (6) juxtaposés, forme une chaîne de résistances (120) branchées en série,
- les modules de raccordement (6) étant respectivement équipés d'un disjoncteur (24) actionnable avec un deuxième contrôleur (118) interne au disjoncteur et avec un élément de commutation (124), lequel envoie au premier contrôleur (116) un signal de contrôleur (C) correspondant à la tension (Uᵢ) qui chute aux bornes de la résistance de socle (112) respective,
- une valeur de résistance totale de la chaîne de résistances (120) et, à l'aide de la valeur de résistance totale, une valeur de nombre (A) correspondant au certain nombre de modules de raccordement (6) accordés étant définies par le premier contrôleur (116),
- une opération de recherche visant à déterminer la position de l'interruption (128) étant déclenchée dans le cas d'une interruption (128) galvanique de la chaîne de résistances (120),
- au début de l'opération de recherche, tous les deuxièmes contrôleurs (118) raccordés étant placés dans un état de commutation avec lequel l'élément de commutation (124) respectif est fermé, et
- la valeur de nombre (A) du nombre de modules de raccordement (6) raccordés étant définie pendant l'opération de recherche,
- des adresses d'appareil (Gᵢ) étant distribuées aux deuxièmes contrôleurs (118) raccordés, et
- le deuxième contrôleur (118) ayant la première adresse d'appareil (G₁) et l'élément de commutation (124) associé étant mis hors circuit.

2. Procédé selon la revendication 1, des adresses d'appareil (Gᵢ) spécifiques aux modules étant envoyées aux deuxièmes contrôleurs (118) raccordés en fonction des signaux de contrôleur (C) des deuxièmes contrôleurs (118) .

3. Procédé selon la revendication 2, les adresses d'appareil (Gᵢ) étant converties en un jeu d'adresses logiques (Lᵢ) correspondant à l'ordre des modules de raccordement (6) juxtaposés les uns aux autres en fonction de la valeur de nombre (A).

4. Procédé selon la revendication 2 ou 3, l'opération de recherche prenant fin lorsqu'il n'existe aucun deuxième contrôleur (118) ayant la première adresse d'appareil (G₁).

5. Coffret de distribution électrique (2) comprenant un premier contrôleur (116) et comprenant un certain nombre de modules de raccordement (6) raccordés à celui-ci destinés au montage sur un rail porteur (20),
- chaque module de raccordement (6) possédant un certain nombre de contacts de couplage latéraux (94, 96, 98, 100) servant à une liaison de contact électrique et/ou signalétique avec au moins un module de raccordement (6) supplémentaire juxtaposé ou juxtaposable au module de raccordement (6) respectif,
- une résistance de socle (112) étant respectivement connectée en interne au module entre deux contacts de couplage (100a, 100b) de telle sorte que les résistances de socle (112) des modules de raccordement (6) juxtaposés les uns aux autres forment une chaîne de résistances (120) branchées en série,
- les modules de raccordement (6) étant ou pouvant être respectivement équipés d'un disjoncteur (24) actionnable,
- les disjoncteurs (24) possédant respectivement un deuxième contrôleur (118) interne au disjoncteur destiné à détecter une tension (Uᵢ) qui chute aux bornes de la résistance de socle (112) respectivement associée et un élément de commutation (124) qui peut être actionné par le deuxième contrôleur (118), lequel est connecté ou peut être connecté entre la résistance de socle (112) et une borne de masse (72) du module de raccordement (6)
- le deuxième contrôleur (118) envoyant un signal de contrôleur (C) au premier contrôleur (116) en fonction de la tension (Uᵢ) détectée,
- le premier contrôleur (116) possédant une source de courant continu (126) servant à l'alimentation de la chaîne de résistances (120), et
- le premier contrôleur (116) et le deuxième contrôleur (118) étant conçu, du point de vue de la technique de programme et/ou de circuit, pour mettre en oeuvre le procédé selon l'une des revendications 1 à 4.

6. Coffret de distribution électrique (2) selon la revendication 5, une ligne de communication (122) formée par les contacts de couplage (98a, 98b) étant présente pour le cheminement des signaux de contrôleur (C) .

7. Coffret de distribution électrique (2) selon la revendication 5 ou 6,
- le module de raccordement (6) possédant une ouverture de contact (80) qui comprend un contact de socle à enfichage divisé en deux pour un contact à enfichage du disjoncteur (24), et
- la résistance de socle (112) étant connectée entre les contacts partiels de socle à enfichage (80a, 80b) ainsi formés.

8. Coffret de distribution électrique (2) selon la revendication 7,
- la borne de masse (72) étant mise en contact ou pouvant être mise en contact d'un côté avec le deuxième contrôleur (118) respectif et de l'autre côté avec un contact partiel à enfichage du contact à enfichage, et
- l'élément de commutation (124) étant connecté entre la borne de masse (72) et le contact partiel à enfichage.
